# EUROPEAN PATENT SPECIFICATION

(11) **EP 3 429 034 B1**
(45) Date of publication and mention of the grant of the patent: **22.06.2022**
(21) Application number: 17845026.8
(22) Date of filing: 30.06.2017
(51) Int. Cl.: H01R 13/66, H01R 24/28

(54) **CABLE STRUCTURE, POWER CORD STRUCTURE, AND ELECTRICAL DEVICE**
KABELSTRUKTUR, NETZKABELSTRUKTUR UND ELEKTRISCHE VORRICHTUNG
STRUCTURE DE CÂBLE, STRUCTURE DE CORDON D'ALIMENTATION, ET DISPOSITIF ÉLECTRIQUE

(30) Priority: 30.08.2016 CN 201610770061
(43) Date of publication of application: 16.01.2019
(73) Proprietor: Guangdong Midea Kitchen Appliances Manufacturing Co., Ltd., Foshan, Guangdong 528311 (CN); Midea Group Co., Ltd., Foshan, Guangdong 528311 (CN)
(72) Inventor: MA, Jianliang, Foshan Guangdong 528311 (CN); ZHANG, Zhenfeng, Foshan Guangdong 528311 (CN); LI, Songtao, Foshan Guangdong 528311 (CN)
(74) Representative: RGTH
(86) International application number: PCT/CN2017/091316
(87) International publication number: WO 2018/040723

(56) References cited:
- WO-A1-2015/147455
- CN-A- 102 064 436
- CN-A- 102 064 436
- CN-A- 104 241 988
- CN-A- 105 337 126
- CN-A- 105 739 400
- CN-A- 106 299 904
- CN-A- 106 329 241
- CN-U- 203 588 713
- CN-U- 204 425 327
- CN-U- 205 985 620
- CN-U- 206 076 634
- CN-U- 206 196 168
- JP-A- 2003 110 333
- US-A1- 2012 028 488
- US-A1- 2013 279 101

## Description

### Field of the Invention

The present invention relates to the field of electric appliances, and in particular, to a cable structure, a power cord structure and an electrical device.

### Background of the Invention

An electrical device is connected to a network or interconnected with other equipment through different communication modules. The communication modules include, but not limited to, WIFI modules, Bluetooth modules, ZIGBEE modules, and the working principle of the communication modules is to transmit information through wireless signals. The majority of communication modules in related technical solutions adopt microwave communication (microwave: electromagnetic wave of 300 MHz to 300 GHz), the transmission and reception of the wireless signals depend on antennas with specific shapes, and the lower the transmitting and receiving frequency of the communication is, the larger the appearance size of the necessary antenna is. The wireless signals are difficult to penetrate through metals and will be shielded by the metals; the wireless signals will be interfered by noise with the same frequency range, so that the communication cannot be carried out; the strength of the wireless signal decays quickly with distance; the communication modules are electronic components and require specific temperature ranges, humidity ranges and very small electromagnetic interference to work normally; and the antennas of the communication modules must be away from the metals. The structure design of the communication module on the electrical device in related art mainly includes the following several manners:
The communication module is designed in the electrical device. In this manner, the communication module will be shielded by a metal shell of the electrical device and will also be interfered by a motor, a circuit board, coils, a magnetron and the like in the household appliance.

The communication module is designed on the shell of the electrical device. In this manner, the communication ability of the communication module will be influenced by the metal shell of the electrical device and will be affected by the high temperature produced by the electrical device, and this installation manner will affect the appearance consistency of the household appliance and increase the overall size of the household appliance, thereby being not beautiful or practical.

The communication module is designed in the household appliance, and the antenna of the communication module is led out alone and is designed at the outside of the household appliance. This manner will affect the appearance consistency of the household appliance, and as the additional antenna portion is increased at the outside of the household appliance, the size of the household appliance is increased, thereby being not beautiful or practical. Moreover, the antenna mounted at the outside is liable to damage.

In summary, due to the existing structure design of the communication module, the communication module is vulnerable to being shielded, vulnerable to high temperature and vulnerable to the interference of other electronic devices, and the appearance consistency of the household appliance is also affected, thereby being not beautiful or practical.

WO 2015/147455 discloses an intelligent power plug and a power adapter which are connected to an electronic device and enables signal reception from and transmission to the electronic device and a control device for remotely controlling use of power in the electronic device.

JP 2003 110333 A discloses a main body of an electronic oven, which is a household electrical appliance with communication equipment and a power supply cord connected to commercial power supply. An antenna is incorporated in a power supply plug of the cord.

CN 102 064 436 A discloses an electrical equipment energy-consumption monitoring power wire integrating a wireless network communication function. An electric energy metering module and a wireless network communication module are integrated on a common power supply cable, and the acquisition and the communication of electric energy data are completed when an electric appliance is electrified, wherein an electric energy metering unit is used for sampling and processing voltage and current flowing through a power lead and inputting the obtained data into a wireless network communication unit.

CN 105 739 400 A provides a control device comprising a power supply wire and at least one wireless control device. The power supply wire comprises a plug, a connection head use for being connected with an external device and a wire sheath arranged between the plug and the connection head.

### Summary of the Invention

In order to solve at least one of the above technical problems, the embodiment of one aspect of the present invention provides a cable structure.

The embodiment of a second aspect of the present invention provides a power cord structure. The embodiment of yet another aspect of the present invention provides an electrical device. In view of this, according to the embodiment of one aspect of the present invention, the present invention provides a cable structure, applied to an electrical device, and characterized by including: a power cord; a shell arranged on the power cord; and an antenna arranged in the shell.

The cable structure provided by the present invention includes the power cord and the shell, the shell is arranged on the power cord, and the antenna is arranged in the shell. As the antenna is arranged in the shell and does not need to be exposed to the outside, so that the antenna can be protected from being damaged easily, and the antenna can work in a good environment, thereby guaranteeing the working reliability and stability of the antenna; meanwhile, the shell is arranged on the power cord, so the electrical device does not need to be provided with additional antenna devices, thereby guaranteeing the beauty of the overall appearance, guaranteeing convenience for carrying and improving the user experience. Further, the shell is arranged on the power cord, the position of the shell can be at the middle, the front or different positions satisfying requirements of the power cord, therefore different needs of the user can be satisfied, and the application range is wide.

In the technical solution, as the shell is detachably mounted on the power cord, it is convenient to install and detach, thereby facilitating the maintenance and inspection and improving the efficiency of the after-sales service. Further, when the communication module or the antenna arranged in the shell is damaged, only the shell needs to be replaced, thereby avoiding the replacement of the intact power cord, reducing the cost, improving the utilization rate of the power cord and improving the satisfaction of use of the user.

In the above-mentioned technical solution the power cord includes a first portion and a second portion separated from the first portion; the first portion is connected with the second portion by a connecting element; and the connecting element is arranged in the shell.

In the technical solution, the power cord includes the first portion and the second portion separated from the first portion, and the first portion and the second portion are connected by the connecting element that is arranged in the shell, so the shell can be located at any position of the power cord, accordingly different needs of the user are satisfied, and the application range is wide. Further, the power cord includes the first portion and the second portion, and the lengths of the first portion and the second portion can be set according to the needs of the user, thereby avoiding waste and reducing the cost, and thus the satisfaction degree of use of the user is improved.

The shell is arranged at an end part or a middle portion of the power cord.

In the technical solution, the shell is arranged at the end part or the middle portion of the power cord, the shell is arranged at a proper position according to the specific use environment and function of the electrical device so as to avoid the influence of the metal shell of the electrical device, the high operation temperature, electromagnetic interference and other factors.

The shell is an insulating shell; and the outside of both the power cord and the conducting wire is coated with insulating layers.

In the technical solution, the interference of external factors on the communication module is avoided by the insulating shell, and further, the outside of both the power cord and the conducting wire is coated with the insulating layers, so a strong wire is separated from a weak wire, and the conducting wire is not interfered by the power cord.

The cable structure further includes: a communication module arranged in the shell and connected with the antenna.

In the technical solution, the communication module is arranged in the shell and is arranged on the power cord together with the antenna, thereby not only being able to shorten the connection path between the communication module and the antenna and facilitate signal transmission, but also avoiding increasing additional communication modules and antenna portions at the outside of the electrical device to increase the size of the electrical device, and guaranteeing the appearance consistency, beauty and practicability of the electrical device; meanwhile, as the communication module is arranged on the power cord, the communication module can be far away from the electrical device, so the communication ability of the communication module will not be shielded by the metal shell of the electrical device, and will not be affected by a motor, a circuit board, coils, a magnetron and other factors in the electrical device, or affected by the high temperature caused by the operation of the equipment, accordingly the communication module works in a good environment, and the working reliability and stability of the communication module are guaranteed.

The cable structure further includes: a conducting wire, wherein one end of the conducting wire is connected with the communication module or the antenna, and the other end of the conducting wire is connected with the electrical device.

In the technical solution, on the one hand, when both the communication module and the antenna are arranged in the shell, the antenna is connected with the communication module, and the antenna quickly transmits a received signal to the communication module and transmits the signal to the electrical device through the conducting wire so as to realize the intelligent control of the electrical device. On the other hand, the communication module and the antenna are not located on the same position, the communication module can be designed in the electrical device or on the shell, the antenna of the communication module is led out by the conducting wire and is designed on the power cord, and the antenna transmits the signal to the communication module of the electrical device through the conducting wire after receiving the signal so as to realize the intelligent control of the electrical device.

In addition, the cable structure in the above-mentioned embodiment provided by the present invention can further have the following additional technical features:
In the above-mentioned technical solution, preferably, the shell is detachably mounted on the power cord.

In the above-mentioned technical solution, preferably, the connecting element includes a power cord docking interface arranged at the end part of the shell, and a power cord interface arranged on the first portion and the second portion of the power cord and matched with the power cord docking interface.

In the technical solution, by means of the cooperation of the power cord docking interface arranged at the end part of the shell and the power cord interface arranged on the first portion and the second portion of the power cord, the connection of the first portion of the power cord with the shell and the connection of the second portion of the power cord with the shell are realized, and then the power cords of the two portions are connected through the shell. When the portions of the power cord are damaged or the communication module and the antenna are damaged, only the power cord of the damaged portion or the communication module and the antenna need to be replaced, thereby avoiding the replacement of the power cord of the other intact portion, reducing the cost, improving the utilization rate of the power cord and improving the satisfaction degree of use of the user.

In the above-mentioned technical solution, preferably, a cover body is arranged on the shell, and the cover body is detachably mounted on the shell.

In the technical solution, as the cover body is arranged on the shell, and the cover body is detachably mounted on the shell, when any one of the communication module, the antenna and the conducting wire in the shell is damaged, troubleshooting is facilitated for maintenance and component replacement.

In the above-mentioned technical solution, preferably, the conducting wire and the power cord are of an integrated structure, and the conducting wire is integrated in the power cord.

In the technical solution, the conducting wire for connecting the communication module with the electrical device is integrated with the power cord, so that the connecting circuits of the communication module and the power supply with the electrical device are merged, the circuit layout is more neat, meanwhile a rubber coating structure of the power cord protects the conducting wire, thereby not only prolonging the service life of the conducting wire, but also guaranteeing the safety of daily use of the user.

In any one of the above-mentioned technical solutions, preferably, the power cord at least includes a power live wire and a power zero line.

In the technical solution, on the one hand, the power cord is a 3PIN power cord and includes the power live wire, the power zero line and a power ground line; and on the other hand, the power cord is a 2PIN power cord and includes the power live wire and the power zero line. Different structures of the power cord can satisfy different needs of the user, and thus the application range is wide.

According to the embodiment of the second aspect of the present invention, a power cord structure is further provided, applied to an electrical device, including: a power cord plug; and the cable structure in any one of the above-mentioned technical solutions; and the power cord plug is connected with the cable structure.

The power cord structure provided by the embodiment of the second aspect of the present invention includes the power cord plug and the cable structure in any one of the above-mentioned technical solutions, therefore the power cord structure has all the beneficial effects of the cable structure, and the cable structure is connected with the electrical device through the power cord plug so as to guarantee the power supply and the connection between the communication module and the electrical device.

In the above-mentioned technical solution, preferably, the power cord structure further includes a power cord connector, and the power cord connector is connected with one end of the cable structure opposite to the power cord plug.

In the technical solution, one end of the cable is connected with the power cord plug, the other end of the cable is connected with the power cord connector, due to the arrangement of the power cord connector, the detachment and the deployment of the power cord structure are facilitated, meanwhile when any component in the power cord structure is damaged, a new power cord structure is just replaced, thereby generating no influence on the use of the overall machine of the electrical device, reducing the cost and improving the satisfaction degree of use of the user.

In the above-mentioned technical solution, preferably, the power cord connector includes: a power cord interface connected with the power cord; and a data line interface connected with the conducting wire.

In the technical solution, the power cord connector is provided with the power cord interface and the data line interface, which can be respectively connected with the power cord and the conducting wire, therefore the power supply is connected with the electrical device through the power cord to provide electric power for the electrical device, and the communication module or the antenna is connected with the electrical device to transmit signals so as to realize the intelligent control of the electrical device.

According to the embodiment of yet another aspect of the present invention, an electrical device is further provided, including: the cable structure in any one of the above-mentioned technical solutions; or the power cord structure in any one of the above-mentioned technical solutions.

The electrical device provided by the embodiment of yet another aspect of the present invention includes the cable structure provided by the embodiment of the first aspect of the present invention or the power cord structure provided by the embodiment of the second aspect, the communication module or the antenna can be hermetically arranged on the power cord, so the antenna does not need to be exposed to the outside and is unlikely to be damaged, and the communication module is also far away from the electrical device, so the communication ability of the communication module will not be shielded by the metal shell of the electrical device, and will not be affected by the motor, the circuit board, the coils, the magnetron and other factors in the electrical device, or affected by the high temperature caused by the operation of the equipment, accordingly the communication module or the antenna works in a good environment, and the working reliability and stability of the communication module or the antenna are guaranteed; no additional size is added to the electrical device, thereby guaranteeing the beauty of the overall appearance, guaranteeing convenience for carrying and improving the user experience; meanwhile, the communication module having complete functions can satisfy comprehensive needs of the user for all kinds of electrical device, thereby improving the application range of the power cord structure; and the detachable power cord structure reduces the maintenance and component replacement cost of the electrical device, prolongs the service life of the overall machine of the electrical device and improves the satisfaction degree of use of the user.

In the above-mentioned technical solution, preferably, the electrical device is a household appliance, including: a microwave oven, a microwave oven, an oven and a water heater.

In the technical solution, the cable structure or the power cord structure is applied to the microwave oven, the microwave oven, the oven and the water heater, the user can conveniently and remotely control these household appliances, including, but not limited to, opening and closing the household appliances, setting expected values, adjusting operation modes and the like, and can also transmit menus to the microwave oven, the microwave oven and the oven for automatic cooking.

Additional aspects and advantages of the present invention will become apparent from the following description.

### Brief Description of the Drawings

The foregoing and/or additional aspects and advantages of the present invention will become apparent and understandable from the following description of the embodiments in conjunction with the accompanying drawings, wherein:
Fig. 1 is a schematic diagram of a power cord structure in an exemplary embodiment not forming part of the invention;
Fig. 2 is a schematic diagram of a power cord structure in an exemplary embodiment not forming part of the invention;
Fig. 3 is a schematic diagram of a power cord structure in an embodiment of the present invention;
Fig. 4 is a structural schematic diagram of a power cord plug in an embodiment of the present invention.

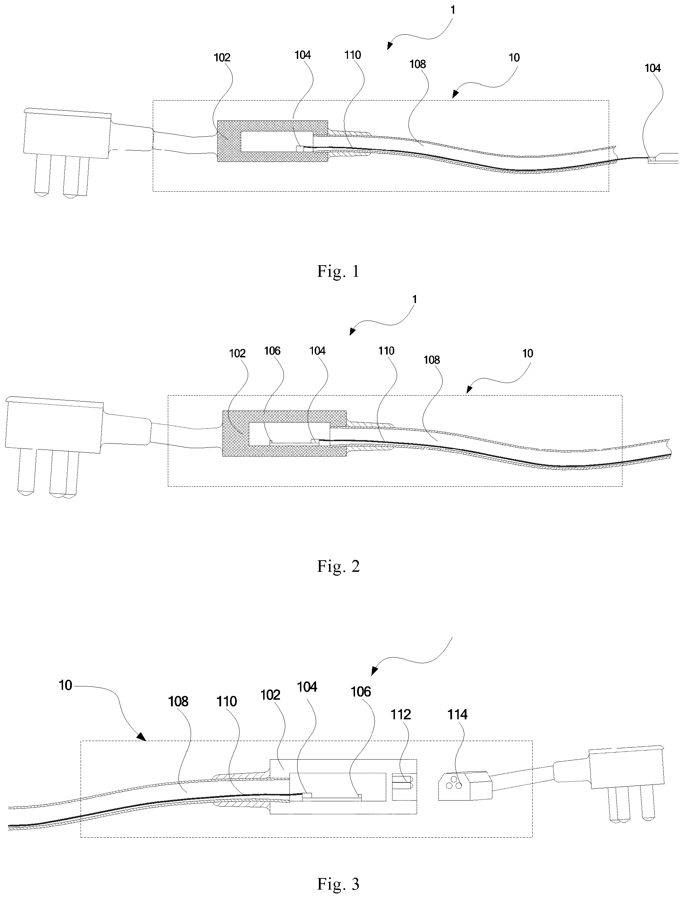

The corresponding relationship between reference signs in Fig. 1 to Fig. 4 and component names is as follows:
1 power cord structure, 10 cable structure, 102 shell, 104 antenna, 106 communication module, 108 power cord, 110 conducting wire, 112 power cord docking interface, 114 power cord interface, 12 power cord plug, 14 power cord connector, 142 power cord interface, and 144 data line interface.

### Detailed Description of the Embodiments

In order that the above-mentioned objectives, features and advantages of the present invention can be understood more clearly, a further detailed description of the present invention will be given below in combination with the accompanying drawings and embodiments. It should be noted that, in the absence of a conflict, the embodiments of the present application and the features in the embodiments can be combined with each other.

A lot of specific details are set forth in the following description so as to fully understand the present invention, but the present invention may also be implemented in other ways other than those described herein, and thus the protection scope of the present invention is only limited by the scope of the claims.

A cable structure according to some embodiments of the present invention will be described below with reference to Fig. 1 to Fig. 4.

As shown in Fig. 1, the exemplary embodiment provides a cable structure 10, applied to an electrical device, and characterized by including: a power cord 108; a shell 102 arranged on the power cord; and an antenna 104 arranged in the shell 102.

The cable structure 10 provided includes the power cord 108 and the shell 102, the shell 102 is arranged on the power cord 108, and the antenna 104 is arranged in the shell 102. As the antenna 104 is arranged in the shell 102 and does not need to be exposed to the outside, so that the antenna 104 can be protected from being damaged easily, and the antenna 104 can work in a good environment, thereby guaranteeing the working reliability and stability of the antenna 104; meanwhile, the shell 102 is arranged on the power cord, so the electrical device does not need to be provided with additional antenna 104 devices, thereby guaranteeing the beauty of the overall appearance, guaranteeing convenience for carrying and improving the user experience. Further, the shell 102 is arranged on the power cord, according to the invention the position of the shell 102 can be at the middle portion or the end part of the power cord, satisfying requirements of the power cord, therefore different needs of the user can be satisfied, and the application range is wide.

In addition, the cable structure 10 in the above-mentioned embodiment can further have the following additional technical features:

In an embodiment of the present invention, as shown in Fig. 2, the cable structure further includes: a communication module 106 arranged in the shell 102 and connected with the antenna 104.

In the invention, the communication module 106 is arranged in the shell 102 and is arranged on the power cord 108 together with the antenna 104, thereby not only being able to shorten the connection path between the communication module 106 and the antenna 104 and facilitate signal transmission, but also avoiding increasing additional communication modules 106 and antenna 104 portions at the outside of the electrical device to increase the size of the electrical device, and guaranteeing the appearance consistency, beauty and practicability of the electrical device; meanwhile, as the communication module 106 is arranged on the power cord, the communication module 106 can be far away from the electrical device, so the communication ability of the communication module 106 will not be shielded by the metal shell of the electrical device, and will not be affected by a motor, a circuit board, coils, a magnetron and other factors in the electrical device, or affected by the high temperature caused by the operation of the equipment, accordingly the communication module 106 works in a good environment, and the working reliability and stability of the communication module 106 are guaranteed.

Further, for example, a microwave oven includes the communication module 106, if the communication module 106 works at 2.412 GHz to 2.472 GHz, and the microwave center frequency of the microwave oven is 2.45GHz, then the microwave oven will generate the same frequency interference on the communication module 106, the communication module 106 is arranged in the shell 102 on the power cord 108 located at the outside of the microwave oven, so the communication module 106 is far away from the microwave oven, the same frequency interference of the communication module 106 generated by the microwave oven is effectively reduced, or the microwave oven cannot interfere the communication module 106, therefore the communication ability of the communication module 106 will not be affected by the motor, the circuit board, the coils, the magnetron and other factors in the electrical device, and the satisfaction degree of use of the user is improved. Further, for example, a water heater includes the communication module 106, the shell of the water heater is generally of a full-metal sealed structure, if the communication module 106 is designed in the water heater, the communication module 106 will be shielded by the metal and cannot work, the communication module 106 is arranged in the shell 102 on the power cord 108 located at the outside of the water heater, so the communication module 106 is far away from the water heater, and the interference of the communication module 106 generated by a metal outer wall of the water heater is effectively avoided, therefore the communication ability of the communication module 106 will not be shielded by the metal shell of the electrical device, and the satisfaction degree of use of the user is improved.

Further, for example, an oven includes the communication module 106, the majority of the working temperatures of the oven are higher than 200 degrees centigrade, the oven continuously dissipates heat, so the surrounding of the shell of the oven is a high temperature area, which does not satisfy the specific temperature needs for the working of the communication module 106, thereby affecting the working effect of the communication module 106, as the communication module 106 is arranged in the shell 102 on the power cord 108 away from the oven and located at the outside of the oven, the communication module 106 works in a good environment, and the working reliability and stability of the communication module 106 are guaranteed. Further, for example, an air conditioner includes the communication module 106, and the antenna 104 connected with the communication module 106 is led to the outside of the air conditioner, thereby affecting the overall reliability and beauty of the air conditioner, accordingly the communication module 106 is arranged in the shell 102 on the power cord 108 located at the outside of the air conditioner, thereby increasing no additional size of the electrical device, guaranteeing the beauty of the overall appearance, being higher in practicability and improving the satisfaction degree of use of the user.

In the invention, as shown in Fig. 1 to Fig. 3, the cable structure further includes: a conducting wire 110, one end of the conducting wire 110 is connected with the communication module 106 or the antenna 104, and the other end of the conducting wire is connected with the electrical device.

In the embodiment, on the one hand, when the communication module 106 and the antenna 104 are arranged in the shell 102, the antenna 104 is connected with the communication module 106, and the antenna 104 quickly transmits a received signal to the communication module 106 and transmits the signal to the electrical device through the conducting wire 110 so as to realize the intelligent control of the electrical device. On the other hand, not forming part of the invention, the communication module 106 and the antenna 104 are not located on the same position, the communication module 106 can be designed in the electrical device or on the shell, the antenna 104 of the communication module 106 is led out by the conducting wire 110 and is designed on the power cord 108, the antenna 104 transmits the signal to the communication module 106 of the electrical device through the conducting wire 110 after receiving the signal so as to realize the intelligent control of the electrical device.

According to the present invention, as shown in Fig. 3, the shell 102 is detachably mounted on the power cord.

In the embodiment, as the shell 102 is detachably mounted on the power cord 108, it is convenient to install and detach, thereby facilitating the maintenance and inspection and improving the efficiency of the after-sales service. Further, when the communication module 106 or the antenna 104 arranged in the shell 102 is damaged, only the shell 102 needs to be replaced, thereby avoiding the replacement of the intact power cord 108, reducing the cost, improving the utilization rate of the power cord and improving the satisfaction degree of use of the user.

According to the present invention, as shown in Fig. 3, the power cord 108 includes a first portion and a second portion separated from the first portion; the first portion is connected with the second portion by a connecting element; and the connecting element is arranged in the shell 102.

In the embodiment, the power cord 108 includes the first portion and the second portion separated from the first portion, and the first portion and the second portion are connected by the connecting element that is arranged in the shell 102, so the shell 102 can be located at any position of the power cord 108, accordingly different needs of the user are satisfied, and the application range is wide. Further, the power cord 108 includes the first portion and the second portion, and the lengths of the first portion and the second portion can be set according to the needs of the user, thereby avoiding waste and reducing the cost, and thus the satisfaction degree of use of the user is improved.

In an embodiment of the present invention, preferably, as shown in Fig. 3, the connecting element includes a power cord docking interface 112 arranged at the end part of the shell 102, and a power cord interface 114 arranged on the first portion and the second portion of the power cord 108 and matched with the power cord docking interface 112.

In the embodiment, by means of the cooperation of the power cord docking interface 112 arranged at the end part of the shell 102 and the power cord interface 114 arranged on the first portion and the second portion of the power cord 108, the connection of the first portion of the power cord with the shell 102 and the connection of the second portion of the power cord with the shell 102 are realized, and then the power cords 108 of the two portions are connected through the shell 102. When the portions of the power cord 108 are damaged or the communication module 106 and the antenna 104 are damaged, only the power cord 108 of the damaged portion or the communication module 106 and the antenna 104 need to be replaced, thereby avoiding the replacement of the power cord of the other intact portion, reducing the cost, improving the utilization rate of the power cord 108 and improving the satisfaction degree of use of the user.

In an embodiment of the present invention, preferably, a cover body is arranged on the shell 102, and the cover body is detachably mounted on the shell 102.

In the embodiment, as the cover body is arranged on the shell 102, and the cover body is detachably mounted on the shell 102, when any one of the communication module 106, the antenna 104 and the conducting wire 110 in the shell 102 is damaged, troubleshooting is facilitated for maintenance and component replacement.

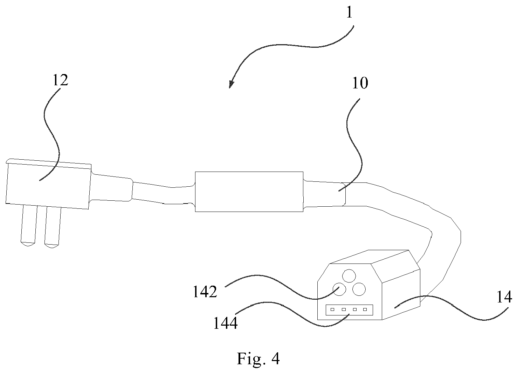

In an embodiment of the present invention, preferably, as shown in Fig. 4, the conducting wire 110 and the power cord 108 are of an integrated structure, and the conducting wire 110 is integrated in the power cord 108.

In the embodiment, the conducting wire 110 for connecting the communication module 106 with the electrical device is integrated with the power cord, so that the connecting circuits of the communication module 106 and the power supply with the electrical device are merged, the circuit layout is more neat, meanwhile a rubber coating structure of the power cord 108 protects the conducting wire 110, thereby not only prolonging the service life of the conducting wire 110, but also guaranteeing the safety of daily use of the user.

In an embodiment of the present invention, preferably, the shell 102 is arranged at an end part or a middle portion of the power cord.

In the embodiment, the shell 102 is arranged at the end part or the middle portion of the power cord 108, the shell is arranged at a proper position according to the specific use environment and function of the electrical device so as to avoid the influence of the metal shell 102 of the electrical device, the high operation temperature, electromagnetic interference and other factors.

In an embodiment of the present invention, preferably, the shell 102 is an insulating shell 102; and both the power cord and the conducting wire 110 are coated with insulating layers .

In the technical solution, the interference of external factors to the communication module 106 is avoided by the insulating shell 102, and further, the outside of both the power cord 108 and the conducting wire 110 is coated with the insulating layers , so a strong wire is separated from a weak wire, and the conducting wire 110 is not interfered by the power cord. In an embodiment of the present invention, preferably, the power cord 108 at least includes a power live wire and a power zero line.

In the embodiment, on the one hand, the power cord 108 is a 3PIN power cord and includes the power live wire, the power zero line and a power ground line; and on the other hand, the power cord 108 is a 2PIN power cord and includes the power live wire and the power zero line. Different numbers of the power cord interfaces 142 can satisfy different needs of the user, and thus the application range is wide. Further, there may be 4 data line interfaces 144, meanwhile four conducting wires 110 are connected, further the number of the data line interfaces 144 can be any number satisfying the needs, and different forms of the data line interfaces 144 can satisfy different needs of the user, and thus the application range is wide. According to the embodiment of the second aspect of the present invention, a power cord structure 1 is further provided, applied to an electrical device, including: a power cord plug 12; and the cable structure 10 in any one of the above-mentioned technical solutions; and the power cord plug 12 is connected with the cable structure 10.

The power cord structure 1 provided by the embodiment of the second aspect of the present invention includes the power cord plug 12 and the cable structure 10 in any one of the above-mentioned technical solutions connected with the power cord plug, therefore the power cord structure has all the beneficial effects of the cable structure 10, and the cable structure 10 is connected with the electrical device through the power cord plug 12 so as to guarantee the power supply and the connection between the communication module 106 and the electrical device.

In an embodiment of the present invention, preferably, as shown in Fig. 4, the power cord structure further includes a power cord connector 14, and the power cord connector 14 is connected with one end of the cable structure 10 opposite to the power cord plug 12.

In the embodiment, one end of the cable is connected with the power cord plug 12, the other end of the cable is connected with the power cord connector 14, due to the arrangement of the power cord connector 14, the detachment and the deployment of the power cord structure 1 are facilitated, meanwhile when any component in the power cord structure 1 is damaged, a new power cord structure 1 is just replaced, thereby generating no influence on the use of the overall machine of the electrical device, reducing the cost and improving the satisfaction degree of use of the user.

In an embodiment of the present invention, preferably, as shown in Fig. 4, the power cord connector 14 includes: a power cord interface 142 connected with the power cord; and a data line interface 144 connected with the conducting wire 110.

In the embodiment, the power cord connector is provided with the power cord interface 142 and the data line interface 144, which can be respectively connected with the power cord 108 and the conducting wire 110, therefore the power supply is connected with the electrical device through the power cord 108 to provide electric power for the electrical device, and the communication module 106 or the antenna 104 is connected with the electrical device to transmit signals so as to realize the intelligent control of the electrical device.

According to the embodiment of yet another aspect of the present invention, an electrical device is further provided, including: the cable structure 10 in any one of the above-mentioned technical solutions; or the power cord structure 1 in any one of the above-mentioned technical solutions.

The electrical device provided by the embodiment of yet another aspect of the present invention includes the cable structure 10 provided by the embodiment of one aspect of the present invention or the power cord structure 1 provided by the embodiment of the second aspect, the communication module 106 or the antenna 104 can be hermetically arranged on the power cord 108, so the antenna 104 does not needs to be exposed to the outside and is unlikely to be damaged, and the communication module 106 is also far away from the electrical device, so the communication ability of the communication module will not be shielded by the metal shell of the electrical device, and will not be affected by the motor, the circuit board, the coils, the magnetron and other factors in the electrical device, or affected by the high temperature caused by the operation of the equipment, accordingly the communication module 106 or the antenna 104 works in a good environment, and the working reliability and stability of the communication module 106 or the antenna 104 are guaranteed; no additional size is added to the electrical device, thereby guaranteeing the beauty of the overall appearance, guaranteeing convenience for carrying and improving the user experience; meanwhile, the communication module 106 has complete functions and can satisfy comprehensive needs of the user for all kinds of electrical device, thereby improving the application range of the power cord structure 1; and the detachable power cord structure 1 reduces the maintenance and component replacement cost of the electrical device, prolongs the service life of the overall machine of the electrical device and improves the satisfaction degree of use of the user.

In an embodiment of the present invention, preferably, the electrical device is a household appliance, including: a microwave oven, a microwave oven, an oven and a water heater.

In the embodiment, the cable structure 10 or the power cord structure 1 is applied to the microwave oven, the microwave oven, the oven and the water heater, the user can conveniently and remotely control these household appliances, including, but not limited to, opening and closing the household appliances, setting expected values, adjusting operation modes and the like, and can also transmit menus to the microwave oven, the microwave oven and the oven for automatic cooking.

In the present invention, the term "plural" means two or more, unless otherwise expressly stated. The terms "mounted", "connected", "connection", "fixed" and the like should be generally understood. For example, the "connection" may be a fixed connection and may also be a detachable connection or an integrated connection; and the "connected" may be directly connected and can also be indirectly connected through an intermediate medium. The specific meaning of the above-mentioned terms in the present invention may be understood by those of ordinary skill in the art in light of specific circumstances.

In the descriptions of the present specification, the descriptions of the terms "one embodiment", "some embodiments", "specific embodiments" and the like mean that the specific features, structures, materials or features described in combination with the embodiments or examples are included in at least one embodiment or example of the present invention. In the present specification, the schematic expression of the above-mentioned terms does not necessarily refer to the same embodiment or example.

## Claims

1. . A cable structure (10), applied to an electrical device, comprising:
a power cord (108) ; an insulating shell (102) arranged at an end part or a middle portion of the power cord (108); and
an antenna (104) arranged in the shell, a communication module (106) arranged in the shell (102) and connected with the antenna (104) and a conducting wire (110), wherein one end of the conducting wire (110) is connected with the communication module (106) or the antenna (104), and the other end of the conducting wire (110) is connected with the electrical device, **characterized in that** the shell (102) is detachably mounted on the power cord (108) and that the power cord (108) comprises a first portion and a second portion separated from the first portion; the first portion is connected with the second portion by a connecting element; and
the connecting element is arranged in the shell (102), and **in that** the outside of both the power cord (108) and the conducting wire (110) is coated with insulating layers.

2. . The cable structure (10) of claim 1, wherein,
the connecting element comprises a power cord docking interface (112) arranged at the end part of the shell (102), and a power cord interface (114) arranged on the first portion and the second portion of the power cord (108) and matched with the power cord docking interface (112).

3. . The cable structure (10) of claim 2, wherein,
a cover body is arranged on the shell (102), and the cover body is detachably mounted on the shell (102).

4. . The cable structure (10) of claim 3, wherein,
the conducting wire (110) and the power cord (108) are of an integrated structure, and the conducting wire (110) is integrated in the power cord (108).

5. . The cable structure (10) of any one of claims 1-4, wherein,
the power cord (108) at least comprises a power live wire and a power zero line.

6. . A power cord structure (1), comprising:
a power cord plug (12); and
the cable structure (10) of any one of claims 1-5, and the power cord plug (12) is connected with the cable structure (10).

7. . The power cord structure (1) of claim 6, further comprising:
a power cord connector (14), wherein the power cord connector (14) is connected with one end of the cable structure (10) opposite to the power cord plug (12).

8. . The power cord structure (1) of claim 7, wherein,
the power cord connector (14) comprises:
a power cord interface (142) connected with the power cord (108); and
a data line interface (144) connected with the conducting wire (110).

9. . An electrical device, comprising:
the cable structure (10) of any one of claims 1-5; or
the power cord structure (1) of any one of claims 6-8.

## Patentansprüche

1. Kabelstruktur (10), angewendet bei einer elektrischen Vorrichtung, umfassend:
ein Stromkabel (108);
eine an einem Endteil oder einem Mittelbereich des Netzkabels (108) angeordnete isolierende Umhüllung (102); und
eine in der Umhüllung angeordnete Antenne (104), ein Kommunikationsmodul (106), das in der Ummantelung (102) angeordnet und mit der Antenne (104) verbunden ist, und einen leitenden Draht (110), wobei ein Ende des leitenden Drahts (110) mit dem Kommunikationsmodul (106) oder der Antenne (104) verbunden ist und das andere Ende des leitenden Drahts (110) mit der elektrischen Vorrichtung verbunden ist, **dadurch gekennzeichnet, dass** die Umhüllung (102) lösbar an dem Stromkabel (108) befestigt ist und dass das Stromkabel (108) einen ersten Bereich und einen zweiten Bereich umfasst, der von dem ersten Bereich getrennt ist; der erste Bereich mit dem zweiten Bereich durch ein Verbindungselement verbunden ist; und das Verbindungselement in der Umhüllung (102) angeordnet ist, und dass die Außenseite sowohl des Stromkabels (108) als auch des leitenden Drahts (110) mit Isolierschichten beschichtet ist.

2. Kabelstruktur (10) gemäß Anspruch 1, wobei
das Verbindungselement eine am Endteil der Umhüllung (102) angeordnete Stromkabel-Andockschnittstelle (112) und eine am ersten Bereich und am zweiten Bereich des Stromkabels (108) angeordnete und an die Stromkabel-Andockschnittstelle (112) angepasste Stromkabelschnittstelle (114) umfasst.

3. Kabelstruktur (10) gemäß Anspruch 2, wobei
ein Abdeckkörper auf der Ummantelung (102) angeordnet ist und der Abdeckkörper abnehmbar auf der Ummantelung (102) befestigt ist.

4. Kabelstruktur (10) gemäß Anspruch 3, wobei
der leitende Draht (110) und das Stromkabel (108) eine integrierte Struktur aufweisen und der leitende Draht (110) in das Stromkabel (108) integriert ist.

5. Kabelstruktur (10) gemäß einem der Ansprüche 1-4, wobei das Stromkabel (108) zumindest einen stromführenden Draht und eine Stromnullleitung umfasst.

6. Stromkabelstruktur (1), umfassend:
einen Stromkabelstecker (12); und
die Kabelstruktur (10) gemäß einem der Ansprüche 1-5, und der Stromkabelstecker (12) ist mit der Kabelstruktur (10) verbunden.

7. Stromkabelstruktur (1) gemäß Anspruch 6, ferner umfassend:
einen Stromkabelverbinder (14), wobei der Stromkabelverbinder (14) mit einem dem Netzkabelstecker (12) gegenüberliegenden Ende der Kabelstruktur (10) verbunden ist.

8. Stromkabelstruktur (1) gemäß Anspruch 7, wobei
der Stromkabelverbinder (14) Folgendes umfasst:
eine Stromkabelschnittstelle (142), die mit dem Stromkabel (108) verbunden ist; und
eine Datenleitungsschnittstelle (144), die mit dem leitenden Draht (110) verbunden ist.

9. Elektrische Vorrichtung, umfassend:
die Kabelstruktur (10) gemäß einem der Ansprüche 1-5; oder
die Stromkabelstruktur (1) gemäß einem der Ansprüche 6-8.

## Revendications

1. Structure de câble (10) appliquée à un dispositif électrique, comprenant :
un cordon d'alimentation (108) ;
une coque isolante (102) disposée au niveau d'une partie d'extrémité ou d'une partie centrale du cordon d'alimentation (108) ; et
une antenne (104) disposée dans la coque, un module de communication (106) disposé dans la coque (102) et connecté à l'antenne (104) et un fil conducteur (110), dans laquelle une extrémité du fil conducteur (110) est connectée au module de communication (106) ou à l'antenne (104), et l'autre extrémité du fil conducteur (110) est connectée au dispositif électrique, **caractérisée en ce que** la coque (102) est montée de façon détachable sur le cordon d'alimentation (108) et **en ce que** le cordon d'alimentation (108) comprend une première partie et une deuxième partie séparée de la première partie ; la première partie est connectée à la deuxième partie par un élément de connexion ; et l'élément de connexion est disposé dans la coque (102), et **en ce que** l'extérieur à la fois du cordon d'alimentation (108) et du fil conducteur (110) est revêtu de couches isolantes.

2. Structure de câble (10) selon la revendication 1, dans laquelle
l'élément de connexion comprend une interface d'accueil de cordon d'alimentation (112) disposée au niveau de la partie d'extrémité de la coque (102), et une interface de cordon d'alimentation (114) disposée sur la première partie et la deuxième partie du cordon d'alimentation (108) et adaptée à l'interface d'accueil de cordon d'alimentation (112).

3. Structure de câble (10) selon la revendication 2, dans laquelle
un corps de couverture est disposé sur la coque (102), et le corps de couverture est monté de façon détachable sur la coque (102).

4. Structure de câble (10) selon la revendication 3, dans laquelle le fil conducteur (110) et le cordon d'alimentation (108) font partie d'une structure intégrée, et le fil conducteur (110) est intégré dans le cordon d'alimentation (108).

5. Structure de câble (10) selon l'une quelconque des revendications 1 à 4, dans laquelle
le cordon d'alimentation (108) comprend au moins un fil d'alimentation sous tension et une ligne d'alimentation zéro.

6. Structure de cordon d'alimentation (1) comprenant :
une fiche de cordon d'alimentation (12) ; et
une structure de câble (10) selon l'une quelconque des revendications 1 à 5, et la fiche de cordon d'alimentation (12) est connectée à la structure de câble (10).

7. Structure de cordon d'alimentation (1) selon la revendication 6, comprenant en outre :
un connecteur de cordon d'alimentation (14), le connecteur de cordon d'alimentation (14) étant connecté à une extrémité de la structure de câble (10) opposée à la fiche de cordon d'alimentation (12).

8. Structure de cordon d'alimentation (1) selon la revendication 7, dans laquelle
le connecteur de cordon d'alimentation (14) comprend :
une interface de cordon d'alimentation (142) connectée au cordon d'alimentation (108) ; et
une interface de ligne de données (144) connectée au fil conducteur (110).

9. Dispositif électrique comprenant :
la structure de câble (10) selon l'une quelconque des revendications 1 à 5 ; ou
une structure de cordon d'alimentation (1) selon l'une quelconque des revendications 6 à 8.
